# EUROPÄISCHE PATENTSCHRIFT

(11) **EP 3 857 525 B1**
(45) Veröffentlichungstag und Bekanntmachung des Hinweises auf die Patenterteilung: **31.08.2022**
(21) Anmeldenummer: 19770025.5
(22) Anmeldetag: 13.09.2019
(51) Int. Cl.: G08B 17/113

(54) **SENSOR ZUR VERBINDUNG MIT EINEM FÜGEPARTNER, ADAPTER ZUM MONTIEREN DES SENSORS AN EINEM FÜGEPARTNER SOWIE MONTAGEVERFAHREN ZUM MONTIEREN DES SENSORS UNTER VERWENDUNG DES ADAPTERS AN EINEM FÜGEPARTNER**
SENSOR FOR CONNECTION TO A JOINING PARTNER, ADAPTER FOR INSTALLING THE SENSOR ON A JOINING PARTNER, AND INSTALLATION METHOD FOR INSTALLING THE SENSOR USING THE ADAPTER ON A JOINING PARTNER
CAPTEUR DESTINÉ AU RACCORDEMENT À UN PARTENAIRE D'ASSEMBLAGE, ADAPTATEUR DESTINÉ AU MONTAGE DU CAPTEUR SUR UN PARTENAIRE D'ASSEMBLAGE ET PROCÉDÉ DE MONTAGE PERMETTANT DE MONTER LE CAPTEUR À L'AIDE DE L'ADAPTATEUR SUR UN PARTENAIRE D'ASSEMBLAGE

(30) Priorität: 26.09.2018 DE 102018123767
(43) Veröffentlichungstag der Anmeldung: 04.08.2021
(73) Patentinhaber: Effexx Kommunikations- und Meldesysteme GmbH & Co. KG, 57076 Siegen (DE)
(72) Erfinder: STÄHLER, Paul Jörg, 57234 Wilnsdorf (DE); SCHNEIDER, Axel, 57539 Fürthen (DE)
(74) Vertreter: Wagner Albiger & Partner Patentanwälte mbB
(86) Internationale Anmeldenummer: PCT/EP2019/074499
(87) Internationale Veröffentlichungsnummer: WO 2020/064367

(56) Entgegenhaltungen:
- WO-A1-95/12476
- FR-A1- 3 022 970
- US-A- 5 484 094
- US-A- 5 577 696
- US-A1- 2003 041 696

## Beschreibung

Die Erfindung betrifft ein Montageverfahren zum Montieren eines Sensors unter Verwendung eines Adapters an einem Fügepartner, insbesondere einer Decke.

### Stand der Technik und dessen Nachteile

Bekannte Sensoren werden üblicherweise durch Bohren von Löchern an einer definierten Sollposition an der Decke, der Wand oder einem anderen Untergrund befestigt. Hierzu wird der Sensor zunächst in der Sollposition an dem Untergrund ausgerichtet, sodann werden in diesen Löcher gebohrt und Dübel in diese Löcher eingebracht. Sodann wird der Sensor mit dem Untergrund bzw. der Decke verschraubt. Die korrekte Ausrichtung und Montage dauert üblicherweise ca. 15 Minuten. Dieses ist insbesondere bei der Überkopfmontage relativ kompliziert und somit zeitaufwendig.

Die Montagearbeiten finden in der Regel auf Leitern in größeren Höhen von insbesondere 2 bis 6 Metern statt und während des Anzeichnens und der Montage des Sensors werden beide Hände für die Tätigkeit benötigt. Dieses kann zu schweren Unfällen führen, wenn der Monteur sein Gleichgewicht verliert.

US 5,577,696 A offenbart einen Sensor der genannten Art.

Weiterer Stand der Technik ist bekannt aus FR 3 022 970 A1, WO 95/12476 A1 sowie US 2003/041696 A1 und US 5 484 094 A.

### Aufgabe

Ausgehend von dem eingangs genannten Stand der Technik und den damit verbundenen Nachteilen liegt der Erfindung somit die Aufgabe zugrunde, diese Nachteile zumindest teilweise zu vermeiden und insbesondere ein verbessertes Montageverfahren vorzusehen, dass erheblich einfachere, schneller und sicherere Montage eines Sensors ermöglicht.

### Erfindung

Erfindungsgemäß wird dieses technische Problem in der abstraktesten Ausführungsform bereits durch die Merkmale des unabhängigen Anspruchs gelöst. Vorteilhafte, aber nicht zwingende Weiterentwicklungen sind in den Unteransprüchen wiedergegeben.

Es wird ein Adapter offenbart, der ausgebildet ist um mit einer Adapteroberseite im Wege der Direktmontagetechnik mit dem Gebäude und mit einer Adapterunterseite mit dem Sensor verbunden zu werden. Im Rahmen dieser Direktmontagetechnik, die mit einem Setzgerät, häufig auch als Bolzensetzgerät bezeichneten Vorrichtung durchgeführt wird, erfolgt somit das erfindungsgemäße "Setzen" des Adapters, was bedeutet, dass der Adapter in der Sollposition an dem Fügepartner, insbesondere einer Decke oder Wand oder einem anderen Gebäudeteil, ausgerichtet wird, und sodann mit dem Setzgerät mit dem Fügepartner in der Sollposition, insbesondere unlösbar verbunden wird, indem mindestens ein Nagel, vorzugsweise mehrere Nägel mit dem Setzgerät durch den Adapter durchgeschossen werden, also die durch den Adapter definierte Adapterebene durchdringen. Diese überraschend einfache Maßnahme reduziert die Montagezeit des gesamten Sensors von ca. 15 auf ca. 3 Minuten.

In dem Bolzensetzgerät sind in einem Kunststoffmagazin Nägel verschiedener Größe aufgenommen, welches diese mit einem Druckluft- oder elektrisch betriebenen Kolben durch den Adapter hindurch in die unterliegende Wand oder Decke eintreibt, der Nagel bzw. Bolzen dann mit einem Rand gegen den Adapter anliegt, insbesondere gegen die Adapterunterseite. Bolzensetzgeräte umfassen einen mit pyrotechnischer Energieerzeugung oder elektrischer Energieerzeugung angetriebenen Kolben, der auf einen Bolzen oder Nagel schlägt und so die kinetische Energie des angetriebenen Kolbens auf den Bolzen oder Nagel überträgt. Der Kolben verlässt jedoch niemals das Gerät: Im Fall einer Leersetzung oder beim Setzen auf zu weichen Untergrund bzw. mit Überenergie wird er am Austreten aus dem Gerät durch einen Kolbenstoppring oder Kolbenbremse gehindert. Hierin besteht der wesentliche sicherheitstechnische Unterschied zu den früher verbreiteten Bolzensetzgeräten, die den Nagel wie ein Projektil mit hoher Geschwindigkeit verschossen haben.

Neuere Bolzensetzgeräte sind elektrisch oder akkubetriebene Befestigungsgeräte zur Verwirklichung der Direktmontagetechnik, die also mit Strom oder einem Akku arbeiten. Diese batteriebetriebenen Setzgeräte arbeiten somit staubfrei und wesentlich leiser, so dass diese selbst beim Umbau von Gebäuden im laufenden Betrieb problemlos einsetzbar sind. Außerdem fällt die bei Gas- und Pulversetzgeräten unvermeidliche Geräuschentwicklung weg. Die in Bolzensetzgeräten verwendeten Nägel oder Bolzen sind üblicherweise in Nägelmagazinen aufgenommen, die linear nebeneinander angeordnete Hülsen oder Gitterstrukturen aus Kunststoff umfassen, welche jeweils den einzelnen Nagel umfänglich umschließend aufnehmen und über Verbindungsstege miteinander ähnlich wie ein Patronengurt verbunden sind.

Der Sensor kann beliebig ausgebildet sein, z.B. als Brandmelder, Bewegungsmelder oder aber als Kombination diverser Melder, wobei die Elektronik, Elektrik und/oder Anschlusstechnik in einem durch den Sensor gebildeten Gehäuse bzw. Sensorgehäuse angeordnet ist. Die Technik des Sensors ist in einem Sensorgehäuse aufgenommen.

Der Sensor kann einen mit dem Gebäude verbindbaren Sensorsockel sowie einem vorzugsweise lösbar mit diesem Sensorsockel verbindbaren Sensorkopf umfassen. Dabei können sowohl Sensorsockel also auch der Sensorkopf elektrische und/oder elektronische Komponenten des Sensors aufnehmen, wobei der eigentliche Sensor selbst vorzugsweise im Sensorkopf angeordnet ist. Somit bilden Sensorsockel und Sensorkopf insofern das Gehäuse des Sensors.

Die Befestigung des Adapters mit der Adapteroberseite erfolgt bevorzugt an einer Decke, kann aber auch an beliebigen anderen Fügepartnern erfolgen, z.B. einem Untergrund, einer sich vertikal erstreckenden Wand oder dergleichen.

Der Adapter ist als im Wesentlichen platten- bzw. scheibenförmiges Bauteil ausgebildet, dieser weist also im Verhältnis zu dem Sensor eine deutlich geringe Höhe auf, vorzugsweise nur einige Millimeter, wie z.B. 3-6 mm, so dass der Adapter platten- bzw. scheibenförmig und möglichst unsichtbar in Einbaulage zwischen dem Sensorsockel und dem Fügepartner, also der Wand, Decke bzw. dem Untergrund sitzt. Die Scheibe des Adapters bildet eine Adapterebene, die sich in Einbaulage parallel zur Ebene des Fügepartners erstreckt, also bevorzugt parallel nach unten versetzt zur Decke. Der Adapter hat somit eine wesentlich geringe Höhe als Breite oder Tiefe.

Wenn der Adapter in der bevorzugten Ausführungsform teilweise oder ganz aus Kunststoff besteht, insbesondere als einstückiges Kunststoffspritzgussteil ausgebildet ist, ist dieser auch besonders leicht, wiegt also nur einige Gramm, z.B. 30 Gramm, und kann insofern auch in Montagehöhen von 2 bis 6 Metern, insbesondere 2,5 bis 3 Metern, und insbesondere bei der Überkopfmontage gut und einfach gehandhabt werden.

Bei der besonders bevorzugten Ausführungsform ist der Adapter als im Wesentlichen kreisring- oder torusförmige Scheibe ausgebildet, wobei die Scheibe des Adapters die Adapterebene definiert und der mittige Durchgang in der Scheibe z.B. für die Kabeldurchführung verwendet werden kann.

Der Adapter kann ausgebildet sein, dass dieser in Einbaulage von dem Sensor eingefasst bzw. umschlossen wird, also in Einbaulage bei aufgesetztem Adapter nicht sichtbar ist.

Der Adapter umfasst zwei, besonders bevorzugt zwei diametral an gegenüberliegenden Enden des Adapters ausgebildete, Vertiefungen vorzugsweise in einer durch die Adapterunterseite ausgebildeten Adapterebene, in welche ein Setzkopf des Setzgerätes, aus welchem der Nagel heraustritt, möglichst spielfrei einsetzbar ist, so dass der Nagel durch eine vorzugsweise in dieser Vertiefung vorgesehene Nageldurchgangsöffnung hindurchtritt. Diese Vertiefungen fungieren also als Positioniervertiefungen, welche die genaue Anordnung bzw. Positionierung des Setzgerätes, insbesondere deren Bolzenführung auf dem Adapter vereinfachen. Damit fungiert diese Vertiefung also als Zentrierhilfe für den Setzkopf und auch zur Aufnahme des den jeweiligen Nagel umgebenden Kunststoffs des Nagelmagazins, welches beim Hindurchtreten des Nagels durch die mittige Nagelöffnung in dem Adapter gelöst wird. Wenn das Setzgerät an einem Setzgeräthalter mit Stangen angeordnet ist, erlaubt die erfindungsgemäße Ausgestaltung eine besonders einfache Montage ohne Verwendung von Leitern auch an Decken in einer Höhe von 2 bis 6 Metern. Der Setzgeräthalter nimmt das Setzgerät auf und ist mit mehreren Stangen verbindbar, mit welchen das Setzgerät in die Höhe gehoben und dort betätigt werden kann. Die Stangen können zu Längen bis zu 6 Metern oder länger zusammengesetzt werden.

Am unteren Ende der Stangen ist ein Auslöser für das Setzgerät vorgesehen, mit welchem das in der Setzgeräthalterung aufgenommene Setzgerät auch in größerer Höhe gegen den Untergrund gedrückt und ausgelöst werden kann.

Das Setzgerät kann zudem an der Bolzenführung oder in dessen Nähe, also dem Austrittsende für den Nagel bzw. Bolzen, einen Magneten aufweisen, mit dem dieses einfacher auf einem magnetischen Fügepartner bzw. einem magnetischen Element des Adapters positionierbar bzw. mit diesem verbindbar ist. Der Adapter wird also nur noch auf den an der Bolzenführung des Setzgeräts angeordneten Magneten aufgeschnappt, so dass der Adapter quer zur Bolzenführung des Setzgeräts vorpositioniert ist, und zwar vorzugsweise genau so, dass nach einfachem Andrücken der Adapteroberseite gegen den Fügepartner ohne weites Umsetzen des Setzgeräts im Verhältnis zum Adapter der Nagel nur noch in den Fügepartner gesetzt werden muss, um den Adapter in Solleinbaulage zumindest vorzufixieren.

Dieses bietet für die Arbeitssicherheit den entscheidenden Vorteil, dass für das Setzen des Adapters keine Leiter mehr benötigt wird. Die Montage zumindest des Adapters kann also vom Monteur ohne Verwendung einer Leiter auf dem Boden stehend auch an Fügepartnern in Montagehöhen von vorzugsweise 2 bis 6 Metern ggf. sogar größeren Montagehöhen, bevorzugt aber in einer Montagehöhe von 2,5 bis 3 Metern durchgeführt werden.
1. Somit vermeidet die offenbarte Ausbildung des Adapters mit überraschend einfachen Mitteln das Auf- und Absteigen von der Leiter und ermöglicht die Montage des Adapters, ohne dass der Monteur mit den Händen an der Leiter gesichert ist. Das Montageverfahren an einem Fügepartner, insbesondere unter der Decke in einer Montagehöhe verläuft wie folgt: Aufsetzen eines Adapters mit einem ersten magnetischen Element auf den Magnet an der Vorderseite der Bolzenführung des Setzgeräts, das in einer Setzgeräthalterung angeordnet ist.
2. Anheben des Adapters mit dem Setzgerät über die Setzgeräthalterung und Positionieren unterhalb eines Fügepartners in der Montagehöhe von insbesondere 2 bis 6 Metern, insbesondere einer Decke.
3. Andrücken des Adapters mit der Adapteroberseite gegen den Fügepartner mit dem in dem Setzgeräthalter aufgenommenen Setzgerät.
4. Vorfixieren des Adapters an dem Fügepartner, insbesondere der Decke, mittels Setzen eines ersten Nagels durch den Adapter.
5. Eventuell Anschließen von weiteren Verdrahtungen für das Gehäuse oder von Anschlüssen;
6. Umsetzen der Bolzenführung des Setzgerätes auf ein zweites magnetisches Element des Adapters und Endfixieren des Adapters mittels Setzen eines zweiten Nagels mit dem Fügepartner, insbesondere einer Decke.

Das Endfixieren kann somit auch direkt nach dem Vorfixieren erfolgen.

Setzen bedeutet erfindungsgemäß also, dass der Nagel die durch den Adapter definierte Ebene, also den Adapter durchdringt und den Adapter mit dem Fügepartner verbindet.

Hierzu kann an dem Adapter eine Nageldurchgangsöffnung vorgesehen sein, durch welche der Nagel mit seinem Schaft durch den Adapter hindurchtreten kann, wenn das Setzgerät den Nagel durchsetzt.

Für die Halterung des Adapters an dem Setzgerät umfasst der Adapter ein magnetisches Element mit einer Nageldurchgangsöffnung, insbesondere ausgebildet als Metallscheiben auf der Adapterunterseite.

Auch das magnetische Element weist bei der besonders bevorzugten Ausführungsform eine vorzugsweise zentrale Nageldurchgangsöffnung auf, durch welche der Nagel beim Setzen durchtreten kann.

Bei einer besonders bevorzugten Ausführungsform ist das magnetische Element als an dem Adapter angeordnete, metallische Unterlegscheibe ausgebildet.

Erfindungsgemäss ist das magnetische Element in den Justiervertiefungen angeordnet oder in diesen aufgenommen. Durch die Nageldurchgangsöffnung kann ein Nagel durch das magnetische Element und den Adapter in den in Einbaulage oberhalb der Adapteroberseite angeordneten Decke bzw. den Untergrund hindurchtreten.

Besonders bevorzugt sind zwei magnetische Elemente mit Nageldurchgangsöffnung, insbesondere ausgebildet als Metallscheiben, in zwei diametral gegenüberliegenden Justiervertiefungen an der Adapterunterseite angeordnet bzw. aufgenommen.

Es liegt auch im Rahmen der Erfindung, dass die magnetischen Elemente mit den Nageldurchgangsöffnungen auf der Adapterunterseite z.B. aufgeklebt sind.

Für die korrekte Ausrichtung des Adapters in der Sollposition bietet es sich an, den Adapter mittels eines Markierungs- oder Ortungssystems an der Sollposition auszurichten, besonders einfach erfolgt dieses mittels eines Lasers, insbesondere eines Kreuz-Linienlasers.

Ausführungsformen umfassen auf der Adapteroberseite, welche in Einbaulage dem Gebäude zugewandt ist, an welchem der Adapter befestigt wird, einen Medienschutz zur Verwirklichung ein IP-Schutzklasse, z.B. in Form einer Gummimanschette, einer Membran oder dergleichen, durch welche eine Abdichtung des mittels des Adapters montierten Sensors gegenüber den im Anwendungsfall auftretenden Medien gewährleistet wird. Dieser Medienschutz kann entweder getrennt aufgesetzt sein oder aber bereits oberseitig mit dem Adapter verbunden bzw. auf diesem angeordnet sein, z.B. mittels Verkleben oder Ultraschall-Schweißen.

Weitere Ausführungsformen umfassen Zentrierhilfen zur korrekten und einfachen Anordnung des Sensorkopfes und/oder Sockels auf dem Adapter in der korrekten Montageposition bzw. Ausrichtung. Bevorzugt umfassen diese Zentrierhilfen Stifte, die in Einbaulage in entsprechende Öffnungen des Fügepartners eingreifen. Ausführungsformen umfassen ferner zwei zueinander beabstandete Zentrierstifte, welche zwischen sich einen Abstand definieren und in endseitige Bereiche am Fügepartner eingreifen, insbesondere in ein Langloch.

Bevorzugte Ausführungsformen des Adapters umfassen als Schnellverbindungsmittel ausgebildete Befestigungsmittel zur Befestigung des Adapters an dem Sensor bzw. Sensorsockel. Diese Befestigungsmittel können mit den Zentrierhilfen kombiniert sein.

Beispielsweise können die Befestigungsmittel Rastlaschen umfassen, die mit oder zwischen Zentrierstiften angeordnet sind. Bevorzugt arbeiten diese Rastlaschen federnd und weisen Hinterschnitte bzw. einen Hakenabschnitt auf, welche insbesondere in entgegengesetzte Richtungen arbeiten können.

Dieses hat den Vorteil, dass man an dem einen der beiden Fügepartner (Sensorsockel/Sensorkopf) die Zentrierhilfe mit den Rasthaken vorsieht und an den jeweils anderen Fügepartner an den korrespondierenden Stellen lediglich ein Langloch vorsehen muss, in das die Zentrierstifte an den Enden eingreifen und wobei die Rastarme bzw. Rasthaken zwischenliegend seitlich in Einbaulage das Langloch hintergreifen, besonders bevorzugt beidseitig gegenüberliegend, um eine besonders stabile und zuverlässige Montage zu realisieren.

Als besonders bevorzugt hat sich erwiesen, zwei derartige Paarungen umfassend Zentrierhilfe und Befestigungsmittel vorzusehen, insbesondere umfassend voneinander beabstandete Zentrierstifte, zwischen denen Rastarme bzw. Rasthaken vorgesehen sind, die vorzugsweise ausgebildet sind, um die gegenüberliegenden Ränder bzw. Kanten eines Langlochs anzugreifen, das an dem Fügepartner vorgesehen ist. Vorzugsweise sind die Zentrierhilfen und Rasthaken an dem Adapter und das Langloch an dem Sensorsockel ausgebildet. Ausführungsformen umfassen die Ausbildung des Adapters und des Sensors sowie vorzugsweise des gesamten Montage-Kits aus einem feuerfesten Material. Als zweckmäßig hat sich ABS erwiesen, wobei aber für den Fachmann verständlich ist, dass andere feuerhemmende Materialien ebenfalls einsetzbar sind.

Die Erfindung betrifft ein Montageverfahren zum Montieren eines Adapters für einen Sensor, insbesondere ausgebildet als Brandmelder, an einem Fügepartner, insbesondere einer Decke, in einer Montagehöhe, und zwar ohne Verwendung einer Leiter im Wege der Direktmontagetechnik.

Das vorgeschlagene Montageverfahren umfasst die Verfahrensschritte:
- Aufsetzen eines ersten magnetischen Elements auf einer Adapterunterseite eines scheiben- bzw. plattenförmigen Adapters auf einen Magneten an einer Bolzenführung eines Setzgeräts, das in einer Setzgeräthalterung mit Stangen oder Verlängerungen angeordnet ist;
- Anheben des an der Bolzenführung gehaltenen Adapters mit dem Setzgeräthalter in die Montagehöhe;
- Andrücken des Adapters in der Montagehöhe in einer Montageposition mit einer Adapteroberseite gegen einen Fügepartner, insbesondere eine Decke, und
- Vorfixieren des Adapters an dem Fügepartner mittels Setzen von zumindest einem ersten Nagel durch eine durch die Adapterfläche gebildete Adapterebene des Adapters in der Montagehöhe.

Erfindungsgemäß wird der Adapter zunächst mit einem magnetischen Element auf einen Magneten an der Bolzenführung des Setzgeräts aufgesetzt, das in einer Setzgeräthalterung mit Stangen oder vergleichbaren Verlängerungen aufgenommen ist. Sodann wird das Setzgerät mittels der Stangen des Setzgeräthalters mit dem Adapter in die Montagehöhe, z.B. auf ca. 2 bis 6 Meter angehoben und mit der Adapteroberseite gegen einen Fügepartner gedrückt. Sodann wird der Adapter in der Montagehöhe an dem Fügepartner vorfixiert, indem ein erster Nagel durch den Fügepartner, z.B. eine Decke oder einen Untergrund geschossen wird.

Eine besonders stabile Verbindung des Adapters und somit auch des Sensors mit dem Fügepartner wird realisiert, indem nach dem Vorfixieren das Setzgerät mittels der Setzgeräthalterung auf mindestens ein weiteres magnetisches Element des vorfixierten Adapters umgesetzt wird und der Adapter weiter fixiert wird, indem mindestens ein zweiter Nagel durch den Adapter an dem Fügepartner befestigt wird.

Die magnetischen Elemente an dem Adapter vereinfachen dabei mit überraschend einfachen Mitteln das Umsetzen des Setzgeräts auch in der Montagehöhe in größeren Höhen von bis zu 2 bis 6 Metern, damit mit einer einfachen Seitwärtsbewegung quasi automisch auf der Durchgangsöffnung für den Nagel in dem zweiten magnetischen Element positioniert wird und der zweite Nagel somit nur noch durchgeschossen werden muss.

Falls erforderlich, können in gleicher Weise weitere Nägel an weiteren magnetischen Elementen fixiert werden.

Besonders bevorzugt sind die magnetischen Elemente als Metallscheiben bzw. Metallplättchen mit einer zentralen Durchgangsöffnung für den Nagel ausgebildet, die in korrespondierenden Vertiefungen an einer Unterseite des Adapters eingesetzt sind oder in anderer Weise mit der Unterseite des Adapters verbunden sind, z.B. verklebt sind. Diese Metallscheiben, besonders einfach ausgebildet als Unterlegscheiben, müssen dabei lediglich einen Durchmesser von etwa 5 bis 20 mm aufweisen. Für den Fachmann ist ersichtlich, dass der Adapter und das Montageverfahren nicht auf die Verwendung mit einem Sensor beschränkt ist, sondern auch für andere Vorrichtungen in Gehäusen verwendbar ist, die in größeren Höhen an einem Fügepartner montiert werden müssen. Als Sensoren kommen insbesondere Rauchmelder oder Bewegungsmelder in Betracht.

In der folgenden ausführlichen Beschreibung wird auf die beigefügten Zeichnungen Bezug genommen, die Teil dieser Erfindungsbeschreibung bilden und in denen zur Veranschaulichung spezifische Ausführungsformen gezeigt sind, mit denen die Erfindung ausgeübt werden kann. In dieser Hinsicht wird Richtungsterminologie wie etwa "oben", "unten", "vorne", "hinten", "vorderes", "hinteres", usw. in Bezug auf die Orientierungen der beschriebenen Figur(en) verwendet. Da Komponenten von Ausführungsformen in einer Anzahl verschiedener Orientierung positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Die folgende ausführliche Beschreibung ist nicht im einschränkenden Sinne aufzufassen.

Im Rahmen dieser Beschreibung werden die Begriffe "verbunden", "angeschlossen" sowie "integriert" verwendet zum Beschreiben sowohl einer direkten als auch einer indirekten Verbindung, eines direkten oder indirekten Anschlusses sowie einer direkten oder indirekten Integration. In den Figuren werden identische oder ähnliche Elemente mit identischem Bezugszeichen versehen, soweit dieses zweckmäßig ist.

Bezugszeichenlinien sind Linien, die das Bezugszeichen mit dem betreffenden Teil verbinden. Ein Pfeil hingegen, der kein Teil berührt, bezieht sich auf eine gesamte Einheit, auf die er gerichtet ist. Die Figuren sind im Übrigen nicht unbedingt maßstäblich. Zur Veranschaulichung von Details können möglicherweise bestimmte Bereiche übertrieben groß dargestellt sein. Darüber hinaus können die Zeichnungen plakativ vereinfacht sein und enthalten nicht jedes bei der praktischen Ausführung gegebenenfalls vorhandene Detail. Die Begriffe "oben" und "unten" beziehen sich auf die Darstellung in den Figuren. Es zeigen:
- Figur 1: eine Seitenansicht eines als Brandmelder ausgebildeten Sensors, montiert unterhalb einer Decke;
- Figur 2: einen vergrößerten Querschnitt eines Adapters;
- Figur 3: eine perspektivische Ansicht des Adapters gemäß Figur 2 von unten;
- Figur 4: eine Seitenansicht einer Explosionsdarstellung bzw. eines Montage-Kits gemäß einer bevorzugten Ausführungsform umfassend einen Adapter, einen zwischengeschalteten, ringförmigen Sensorsockel sowie einen mit dem Sensorsockel verbundenen Sensorkopf; und
- Figur 5: eine Draufsicht des Adapters gemäß Figur 4.

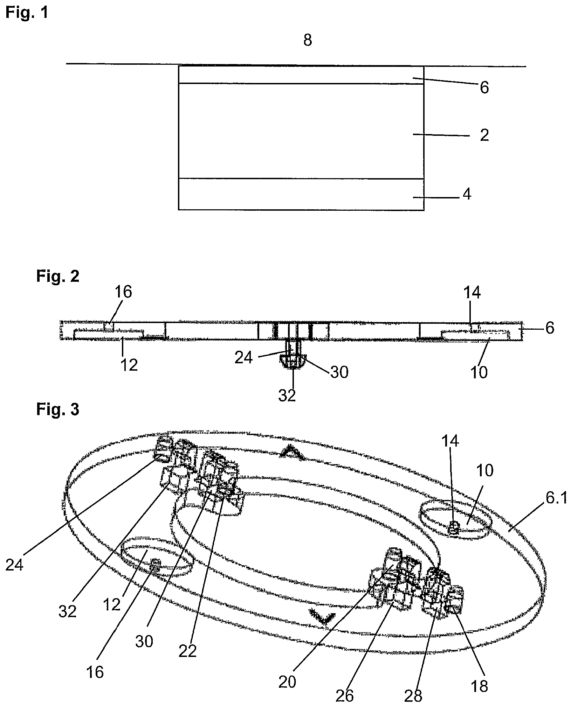

Gemäß Figur 1 umfasst der Sensor einen im Wesentlichen hohlzylindrisch ausgebildeten Sensorsockel 2 sowie einem geometrisch an die Außengeometrie des Sensorsockels 2 angepassten Sensorkopf 4, der Unterseitig lösbar mit dem Sensorsockel 2 befestigt ist. Der Sensorsockel 2 ist mit seinem in Einbaulage oberen Ende über den Adapter 6 mit einer Decke 8 mittels Direktmontage-Technik verbunden.

Bei dieser Ausführungsform weist der als Kunststoffteil ausgebildete Adapter 6 einen Außendurchmesser von ca. 11 cm, eine Höhe von 6 mm und ein Gewicht von etwa 30 Gramm auf. Dazu wird der in den Figuren 2 und 3 näher dargestellte Adapter 6, der im Wesentlichen als Torus-förmiger, also kreisringförmige Scheibe ausgebildet ist, zunächst mit der Adapteroberseite gegen die Decke 8 gedrückt und sodann wird der Setzkopf bzw. Bolzenführung eines Bolzensetzgeräts in kreisförmige Vertiefungen 10, 12 an der Adapterunterseite eingebracht und das Setzgerät ausgelöst. Dabei tritt der aus dem Setzkopf des Setzgeräts austretende Nagel durch eine mittige Nagelöffnung 14, 16 in den Vertiefungen 10, 12 des Adapters 6 hindurch und verbindet sich in bekannter Weise mit der Decke 8 bzw. dem Untergrund.

Der beim Befestigen abgetrennte Teil des Nagelmagazins kann dabei in der Vertiefung 10, 12 an der Adapterunterseite des Adapters 6 aufgenommen werden, so dass kein Material des Magazins über die untere Oberfläche der Adapterunterseite hervorsteht.

Somit ist der Adapter 6 unlösbar in der Sollposition an der Decke 8 befestigt.

Die Befestigung und Ausrichtung des Sensorsockels 2 am Adapter 6 erfolgt mittels kombinierter Zentrierhilfen und Rastmittel, die an der Adapterunterseite an diametral gegenüberliegenden Enden ausgebildet sind. Die Zentriermittel umfassen jeweils voneinander distanzierte, paarweise ausgebildete Zentrierstifte 18, 20 sowie 22, 24, zwischen denen jeweils alternierend fungierende Rastlaschen 26, 28 sowie 30, 32 ausgebildet sind, was bedeutet, dass die Rastlaschen 26, 28 sowie 30, 32 jeweils nach außen wirkende Rasthaken bzw. Hinterschnitte aufweisen, welche in Einbaulage in beidseitige Längsseiten bzw. Längsschenkel eines korrespondierend ausgebildeten Langlochs in dem Sensorsockel 2 eingreifen.

Folglich sind also zwei korrespondierende Langlöcher in dem Sensorsockel 2 vorgesehen, so dass die Montage des Sensorsockels 2 an den Adapter 6 nur in einer vordefinierten und gewünschten Sollposition möglich ist, wie dieses z.B. gemäß den sicherheitstechnischen Erfordernissen vorgeschrieben ist.

Es ist erkennbar, dass die Höhe des Adapters 6 nur etwa 4-5 mm beträgt, also eine deutlich geringere Höhe als der Sensorsockel 2 und der Sensorkopf 4 aufweist. Damit tritt der Adapter 6 größenmäßig im Verhältnis zu der Größe des Sensors völlig in den Hintergrund.

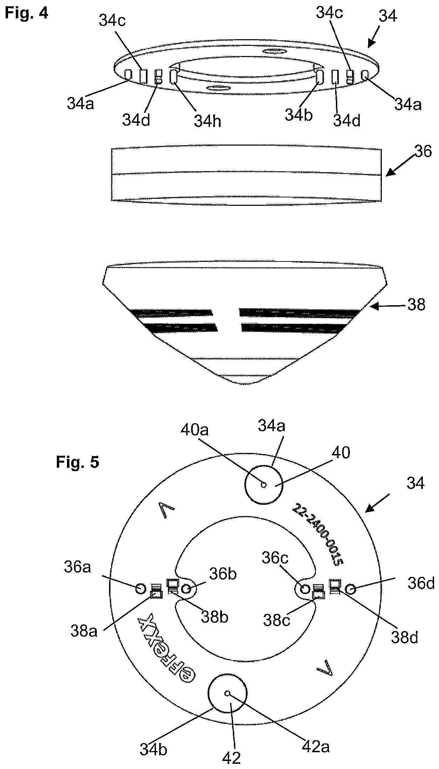

Figur 4 zeigt eine seitliche Explosionsdarstellung eines erfindungsgemäßen Montage-Kits, umfassend einen Adapter 34, einen Sensorsockel 36 sowie einen Sensorkopf 38.

In Einbaulage ist der ringförmige Sensorsockel 36 also mit der Adapterunterseite des scheibenförmigen und mit einer mittigen Durchgangsöffnung versehenden Adapters 34 verrastet, der an einer nicht dargestellten Decke montiert ist. Unterseitig mit dem Sensorsockel 36 ist wiederum der Sensorkopf 38 verrastet, also ebenfalls lösbar befestigt.

Figur 5 zeigt eine Draufsicht des Adapters 34 gemäß Figur 4. Dieser Adapter 34 ist wiederrum als kreisringförmige Scheibe mit einer mittigen Durchgangsöffnung ausgebildet, weist also eine wesentlich größere Länge und Breite als Dicke auf, ist also scheibenförmig ausgebildet und geht gegenüber der Höhe des Sensorsockels 36 und des Sensorkopfes 38 quasi unter. Diese Ausführungsform unterscheidet sich von der in den Figuren 2 und 3 dargestellten Ausführungsform dadurch, dass in den diametral gegenüberliegend in der Adapterunterseite ausgebildeten Vertiefungen 34a, 34b zwei Metallscheiben 40, 42 mit je einer zentralen Nageldurchgangsöffnung 40a, 42a angeordnet bzw. eingesetzt sind, mit denen ein Magnet innerhalb des Setzkopfes eines Setzgerätes verbindbar sind, um somit den Adapter 34 einfach auch in größeren Höhen von 2 bis 6 Metern gegenüber einer Decke oder Wand platzieren und dort befestigen zu können, und zwar ohne Verwendung einer Leiter und somit nur vom Boden her.

Wiederrum erfolgt die Befestigung und Ausrichtung des Sensorsockels 36 am Adapter 34 mittels kombinierter Zentrierhilfen und Rastmittel, die an der Adapterunterseite an diametral gegenüberliegenden Enden ausgebildet sind. Die Zentriermittel umfassen jeweils voneinander distanzierte, paarweise ausgebildete Zentrierstifte 36a - 36d zwischen denen jeweils alternierend fungierende Rasthaken 38a - d angeordnet sind, die in entgegengesetzte Richtungen wirken. Das bedeutet, dass die Rasthaken 38a - d in radialer Richtung zueinander versetzt bzw. voneinander beabstandet sind und sich jeweils quer zur radialen Richtung erstreckende Rasthaken bzw. Hinterschnitte aufweisen, welche in Einbaulage in beidseitige Längsseiten bzw. Längsschenkel eines korrespondierend ausgebildeten Langlochs in dem korrespondierenden Fügepartner eingreifen, insbesondere in den Sensorsockel 3.

Die lösbare Verbindung zwischen Sensorsockel 36 und Sensor 38 erfolgt bevorzugt auf ähnliche Weise wie die zuvor beschriebene Verbindung zwischen Adapter 34 und Sensorsockel 36, kann aber auch auf andere Weise ausgestaltet sein.

### Bezugszeichenliste

- 2: Sensorsockel
- 4: Sensorkopf
- 6: Adapter
- 8: Decke
- 10, 12: Vertiefung
- 14, 16: Nagelöffnung
- 18, 20: Zentrierstift
- 22, 24: Zentrierstift
- 26, 28: Rastlasche
- 30, 32: Rastlasche
- 34: Adapter
- 34a, 34b: Vertiefung
- 36a - d: Zentrierstift
- 38a - d: Rasthaken
- 36: Sensorsockel
- 38: Sensorkopf
- 40, 42: Metallscheibe
- 40a, 42a: Nageldurchgangsöffnung

## Patentansprüche

1. Montageverfahren zum Montieren eines Adapters (6; 34) für einen Sensor oder dergleichen an einem Fügepartner, insbesondere einer Decke, in einer Montagehöhe von ca. 2 bis 6 Metern ohne Verwendung einer Leiter im Wege der Direktmontagetechnik, wobei der Adapter (6; 34) im Wesentlichen scheiben- bzw. plattenartig ausgebildet ist und eine Adapteroberseite sowie eine in Einbaulage mit einem Sensorgehäuse des Sensors lösbar verbindbare Adapterunterseite umfasst, das Montageverfahren umfassend die Verfahrensschritte: Aufsetzen eines ersten magnetischen Elements auf einer Unterseite des Adapters (6; 34) auf einen Magneten an einer Bolzenführung eines Setzgeräts, das in einer Setzgeräthalterung mit Stangen angeordnet ist, Anheben des an der Bolzenführung gehaltenen Adapters (6; 34) über die Stangen des Setzgeräthalters in die Montagehöhe, Andrücken des Adapters in einer Montageposition mit der Adapteroberseite gegen den Fügepartner und Vorfixieren des Adapters (6; 34) an dem Fügepartner mittels Setzen von zumindest einem ersten Nagel durch eine Adapterebene des Adapters (6; 34) in der Montagehöhe, **DADURCH GEKENNZEICHNET, dass** an der Adapterunterseite zwei Vertiefungen (10, 12) mit in diesen angeordneten, magnetischen Elementen vorgesehen sind und dass das Montageverfahren den weiteren Verfahrensschritt nach dem Setzen des ersten Nagels umfasst: Umsetzen der Bolzenführung des Setzgeräts mittels der Setzgeräthalterung in der Montagehöhe, Verbinden des Magnets an der Bolzenführung mit einem zweiten magnetischen Element an der Unterseite des Adapters (6; 34) und Setzen eines zweiten Nagels durch den Adapter (6, 34) zum Endfixieren des Adapters mit dem Fügepartner.

2. Montageverfahren nach Anspruch 1, **DADURCH GEKENNZEICHNET, dass** zwischen dem Vorfixieren und Endfixieren des Adapters (6, 34) in der Montagehöhe eine Verdrahtung bzw. Anschluss des Sensors vorgenommen wird.

3. Montageverfahren nach einem der vorhergehenden Verfahrensansprüche **DADURCH GEKENNZEICHNET, dass** nach Befestigung des Adapters (6, 34) mit dem Fügepartner im Wege der Direktmontagetechnik sodann der Sensor mit dem Adapter (6, 34) insbesondere lösbar verbunden wird.

4. Montageverfahren nach einem der vorhergehenden Verfahrensansprüche, **DADURCH GEKENNZEICHNET, dass** der Adapter (6, 34) vor dem Vorfixieren zunächst an dem Fügepartner ausgerichtet wird, vorzugsweise mittels eines Lasers, insbesondere eines Kreuzlinien-Lasers.

## Claims

1. Installation method for installing an adapter (6; 34) for a sensor or similar on a joining partner, in particular a ceiling, at an installation height of approximately 2 to 6 metres without using a ladder by means of the direct mounting technique, wherein the adapter (6; 34) is substantially panel-like or plate-like in design and comprises an adapter top side and an adapter underside which can be detachably connected to a sensor housing of the sensor in the installation state, the installation method comprising the method steps: setting a first magnetic element on a lower side of the adapter (6; 34) onto a magnet on a pin guide of a setting tool which is arranged in a setting tool holder with rods, lifting the adapter (6; 34) held on the pin guide by means of the rods of the setting tool holder into the installation height, pressing the adapter into an installation position with the adapter top side against the joining partner and pre-fixing the adapter (6; 34) on the joining partner by setting at least one first nail through an adapter plane of the adapter (6; 34) at the installation height, **CHARACTERISED IN that** on the adapter underside are provided two indentations (10, 12) with magnetic elements arranged therein, and that the installation method comprises the further method step after the setting of the first nail: actuation of the pin guide of the setting tool by means of the setting tool holder in the installation height, connecting the magnet on the pin guide to a second magnetic element on the underside of the adapter (6; 34) and setting a second nail through the adapter (6, 34) for finally fixing the adapter on the joining partner.

2. Installation method according to claim 1, **CHARACTERISED IN that** between the pre-fixing and final fixing of the adapter (6, 34) at the installation height a wiring or connection of the sensor is undertaken.

3. Installation method according to any of the preceding method claims, **CHARACTERISED IN that** after fastening the adapter (6, 34) to the joining partner by means of the direct mounting technique, the sensor is connected, in particular detachably, to the adapter (6, 34).

4. Installation method according to any of the proceeding method claims, **CHARACTERISED IN that** prior to the pre-fixing, the adapter (6, 34) Is first aligned on the joining partner, preferably by means of a laser, particularly a cross-line laser.

## Revendications

1. Procédé de montage pour le montage d'un adaptateur (6 ; 34) pour un capteur ou similaire au niveau d'une pièce à assembler, en particulier d'un plafond, à une hauteur de montage d'environ 2 à 6 mètres sans utilisation d'une échelle par la technique de montage direct, dans lequel l'adaptateur (6 ; 34) est conçu pour l'essentiel en forme de disque ou de plaque et comprend une face supérieure d'adaptateur ainsi qu'une face inférieure d'adaptateur qui peut être reliée de manière amovible avec un boîtier de capteur du capteur en position d'installation, le procédé de montage comprenant les étapes de procédé : pose d'un premier élément magnétique sur une face inférieure de l'adaptateur (6 ; 34) sur un aimant au niveau d'un guidage de boulon d'un appareil de pose qui est disposé dans un support d'appareil de pose avec des perches, levage de l'adaptateur (6 ; 34) maintenu au niveau du guidage de boulon via les perches du support d'appareil de pose à la hauteur de montage, poussée de l'adaptateur dans une position de montage avec la face supérieure d'adaptateur contre la pièce à assembler et préfixation de l'adaptateur (6 ; 34) au niveau de la pièce à assembler au moyen de la pose d'au moins une première pointe par le biais d'un plan d'adaptateur de l'adaptateur (6 ; 34) à la hauteur de montage, CARACTÉRISÉ EN QUE deux cavités (10, 12) sont prévues au niveau de la face inférieure d'adaptateur avec des éléments magnétiques disposés dans celles-ci et en ce que le procédé de montage comprend l'étape de procédé supplémentaire après la pose de la première pointe : mise en œuvre du guidage de boulon de l'appareil de pose au moyen du support d'appareil de pose à la hauteur de montage, liaison de l'aimant au niveau du guidage de boulon avec un second élément magnétique au niveau de la face inférieure de l'adaptateur (6 ; 34) et pose d'une seconde pointe par le biais de l'adaptateur (6 ; 34) et fixation définitive de l'adaptateur à la pièce à assembler.

2. Procédé de montage selon la revendication 1, CARACTÉRISÉ EN QUE, entre la préfixation et la fixation finale de l'adaptateur (6 ; 34) à la hauteur de montage un câblage ou un raccordement du capteur est effectué.

3. Procédé de montage selon l'une quelconque des revendications précédentes, CARACTÉRISÉ EN QUE, après la fixation de l'adaptateur (6 ; 34) à la pièce à assembler par la technique de montage direct le capteur est ensuite relié, en particulier de manière amovible, à l'adaptateur (6 ; 34).

4. Procédé de montage selon l'une quelconque des revendications précédentes, CARACTÉRISÉ EN QUE l'adaptateur (6 ; 34) est d'abord orienté vers la pièce à assembler avant la préfixation, de préférence au moyen d'un laser, en particulier un laser à croix.
